# DEMANDE DE BREVET EUROPEEN

(11) **EP 1 755 164 A2**
(43) Date de publication de la demande: **21.02.2007**
(21) Numéro de dépôt: 06291328.0
(22) Date de dépôt: 18.08.2006
(51) Int. Cl.: H01L 27/06, H01L 21/762, H01L 21/20, H01L 21/68

(54) **Procédé d'assemblage de composants passifs et de composants actifs et circuit intégré correspondant**

(30) Priorité: 18.08.2005 FR 0508601
(71) Demandeur: STMicroelectronics SA, 92120 Montrouge (FR)
(72) Inventeur: Giraudin, Jean-Christophe, 38190 Bernin (FR); Marty, Michel, 38760 Varces (FR)
(74) Mandataire: de Kernier, Gabriel

(57) **Abrégé**

La présente invention concerne un circuit intégré comprenant au moins deux sous-ensembles, un sous-ensemble 8 comprenant des composants actifs 11, un sous-ensemble 1 comprenant des composants passifs 6, ledit sous-ensemble 1 comprenant des composants passifs étant fixé sous ledit sous-ensemble comprenant des composants actifs 11 et dans lequel des interconnexions 16 s'étendent d'un sous-ensemble 8 comprenant des composants actifs 11 à un sous-ensemble 1 comprenant des composants passifs.

## Description

La présente invention concerne les circuits intégrés, et plus particulièrement l'assemblage de composants additionnels de hautes performances, notamment des composants passifs, avec des composants actifs.

Un circuit intégré comprend généralement des composants électroniques actifs, notamment des transistors ou des diodes et des composants électroniques passifs, notamment des résistances, des condensateurs ou des inductances.

Les techniques couramment utilisées dans la fabrication d'un circuit intégré pour assembler de tels composants passifs à des composants actifs présentent un certain nombre d'inconvénients liés à la technique mise en oeuvre.

En particulier, une de ces techniques consiste notamment à intégrer sur la surface du substrat des composants passifs au même niveau que des composants actifs. Un tel assemblage présente l'inconvénient d'utiliser jusqu'à 30 % de la surface active du substrat. En outre, ce procédé ne permet pas d'éviter la présence de courants parasitaires entre les composants actifs et les composants passifs limitant ainsi les performances du circuit intégré obtenu. Un tel procédé d'assemblage est décrit dans les articles suivants : Single-chip versus single-package radios, Donnay S et al., 1999 International Conference on High Density Packaging and MCMs et An overview of integrated component technologies, Norlyng S, IMAPS-Int. Microelectron. & Packaging Soc, May-June 2003.

Une autre de ces techniques consiste notamment à effectuer en une seule opération le report et l'interconnexion d'un composant passif sur le substrat. De tels composants sont retournés lors de ce report et sont soudés par l'intermédiaire de plots de connexions se situant à la surface du substrat. Ces plots de connexions se présentent notamment sous la forme de billes ou de bossages métalliques. Ainsi le nombre de composants passifs pouvant être reportés au niveau du substrat est limité par le nombre de plots de connexions réalisés. De tels plots de connexions présentent également l'inconvénient d'utiliser une partie de la surface du substrat disponible pour l'intégration des composants actifs. En outre, ce procédé nécessite de reporter individuellement chacun des composants passifs sur le substrat entraînant une augmentation des coûts dans la fabrication d'un circuit intégré. Cette technique est également décrite dans les articles Single-chip versus single-package radios, Donnay S et al., 1999 International Conference on High Density Packaging and MCMs et An overview of integrated component technologies, Norlyng S, IMAPS-Int. Microelectron. & Packaging Soc, May-June 2003.

Au vu de ce qui précède, l'invention a notamment pour objet de réaliser un assemblage de composants passifs et de composants actifs en utilisant le moins possible la surface de substrat disponible pour l'intégration des composants actifs et en reportant individuellement le moins possible de composants passifs, et ceci tout en minimisant l'influence sur le procédé de fabrication et de fonctionnement des composants actifs.

Selon un aspect, l'invention propose un circuit intégré comprenant au moins deux sous-ensembles, un sous-ensemble comprenant des composants actifs et un sous-ensemble comprenant des composants passifs, ledit sous-ensemble comprenant des composants passifs étant fixé sous ledit sous-ensemble comprenant des composants actifs.

La fixation du sous-ensemble comprenant des composants actifs sur le sous-ensemble comprenant des composants passifs est réalisée par collage. Ce collage est réalisé sans retournement du sous-ensemble comprenant des composants passifs.

On obtient ainsi un circuit intégré présentant des composants actifs dont les caractéristiques ne sont pas sensiblement modifiées par l'intégration des composants passifs.

En outre, on obtient également un circuit intégré dont le sous-ensemble comprenant des composants passifs ne présente pas de difficultés d'alignement avec le sous-ensemble comprenant des composants actifs.

On entend par « composants actifs » au sens de la présente invention, des composants électroniques utilisant les propriétés semiconductrices de certains matériaux tels que par exemple les transistors MOS (Métal Oxyde Semiconducteur), les transistors bipolaires, les transistors à effet de champ (transistors MOSFET) ou les diodes.

On entend par « composants passifs » au sens de la présente invention, des composants électroniques tels que par exemple des résistances, des condensateurs ou des inductances.

Selon une caractéristique de l'invention, le circuit intégré comprend deux sous ensembles fixés mutuellement par l'intermédiaire d'une couche comprenant un matériau à base d'oxyde.

Cette couche permet entre autres de réaliser le collage du sous-ensemble comprenant des composants actifs sur le sous-ensemble comprenant des composants passifs, notamment par force électrostatique. Cette couche présente également une sélectivité de gravure plus importante par rapport au substrat semi-conducteur sur lequel se trouvent les composants actifs.

Selon un mode de réalisation, des interconnexions traversent le sous-ensemble comprenant des composants actifs pour permettre d'assurer une liaison électrique satisfaisante entre les niveaux d'interconnexions situés au-dessus du sous-ensemble comprenant les composants actifs et les composants passifs du circuit intégré. Le contact ohmique obtenu est notamment satisfaisant dans le cas des condensateurs.

Selon une caractéristique de l'invention, lesdites interconnexions relient des composants passifs à des niveaux d'interconnexions disposés au-dessus du sous-ensemble comprenant des composants actifs.

Selon un mode de réalisation avantageux, lesdits niveaux d'interconnexions peuvent également se situer entre le sous-ensemble comprenant des composants actifs et le sous-ensemble comprenant des composants passifs.

Selon un mode de réalisation, lesdites interconnexions s'étendent d'un sous-ensemble comprenant des composants actifs à un sous-ensemble comprenant des composants passifs.

De cette façon, on rapproche les composants actifs et les composants passifs ce qui permet d'éviter les pertes dans les lignes de connexions entre les deux sous-ensembles.

Avantageusement, lesdites interconnexions sont dans des zones isolantes du sous-ensemble comprenant des composants actifs, lesdites zones isolantes étant dépourvues de composants actifs de façon à éviter un court-circuit.

Selon un autre aspect, l'invention a également pour objet un procédé de fabrication d'un circuit intégré comprenant
- une étape consistant à réaliser un sous ensemble comprenant des composants passifs,
- une étape consistant à réaliser un sous ensemble comprenant des composants actifs, et, ultérieurement,
- une étape consistant à fixer ledit sous ensemble comprenant des composants passifs sous ledit sous ensemble comprenant des composants actifs.

Le procédé permet d'éviter que le procédé de fabrication du sous-ensemble comprenant des composants passifs influence sur le procédé de fabrication du sous-ensemble comprenant des composants actifs. Ainsi les caractéristiques des composants actifs ne sont sensiblement pas modifiées par l'assemblage des composants passifs. En outre, l'indépendance des procédés de fabrication permet d'éviter des problèmes d'incompatibilités entre les étapes des deux procédés. Le procédé permet également d'éviter les problèmes d'incompatibilité entre les matériaux des composants actifs et des composants passifs.

Le procédé permet également d'utiliser l'ensemble de la surface du substrat pour la réalisation des composants actifs.

De plus, le procédé permet d'effectuer un report collectif du sous-ensemble comprenant des composants actifs sur le sous-ensemble comprenant des composants passifs.

Selon une caractéristique de l'invention, l'étape consistant à réaliser ledit sous-ensemble comprenant des composants actifs comprend une sous-étape consistant à déposer un matériau permettant de manipuler ledit sous-ensemble comprenant des composants actifs lors de l'étape de fixation ce qui permet de réduire l'influence du procédé sur les caractéristiques des composants actifs.

Avantageusement, l'étape, consistant à réaliser ledit sous-ensemble comprenant des composants actifs, comprend une sous-étape consistant à retirer dudit sous-ensemble un substrat.

Avantageusement, après le retrait du substrat, une étape de fixation dudit sous-ensemble comprenant des composants passifs est mise en oeuvre sous ledit sous-ensemble comprenant des composants actifs.

Selon une caractéristique de l'invention, après l'étape de fixation, une étape consistant à réaliser des interconnexions est mise en oeuvre afin de relier ledit sous-ensemble comprenant des composants actifs audit sous-ensemble comprenant des composants passifs.

Selon un autre mode de réalisation, après le retrait du substrat, on peut mettre également en oeuvre une étape consistant à réaliser des niveaux d'interconnexions entre ledit sous ensemble comprenant des composants actifs et ledit sous ensemble comprenant des composants passifs.

Selon un autre mode de réalisation, après le retrait du substrat, on ajoute des plots conducteurs sous des composants actifs du sous-ensemble comprenant des composants actifs.

D'autres caractéristiques et avantages de l'invention apparaîtront à l'examen de la description détaillée des modes de réalisations et de mise en oeuvre nullement limitatifs et des dessins annexés, sur lesquels :
- la figure 1 illustre schématiquement un sous-ensemble d'un circuit intégré comprenant un condensateur tridimensionnel dans un substrat,
- la figure 2 illustre de façon schématique un sous-ensemble d'un circuit intégré comprenant des composants actifs sur un substrat,
- les figures 3 à 7 illustrent de façon schématique les étapes successives d'un mode de réalisation d'un assemblage du sous-ensemble comprenant des composants actifs et du sous-ensemble comprenant un condensateur,
- la figure 8 illustre un deuxième mode de réalisation d'un assemblage d'un sous-ensemble comprenant des composants actifs et d'un sous-ensemble comprenant un condensateur.
- la figure 9 illustre un troisième mode de réalisation d'un assemblage d'un sous-ensemble comprenant des composants actifs et d'un sous-ensemble comprenant un condensateur.

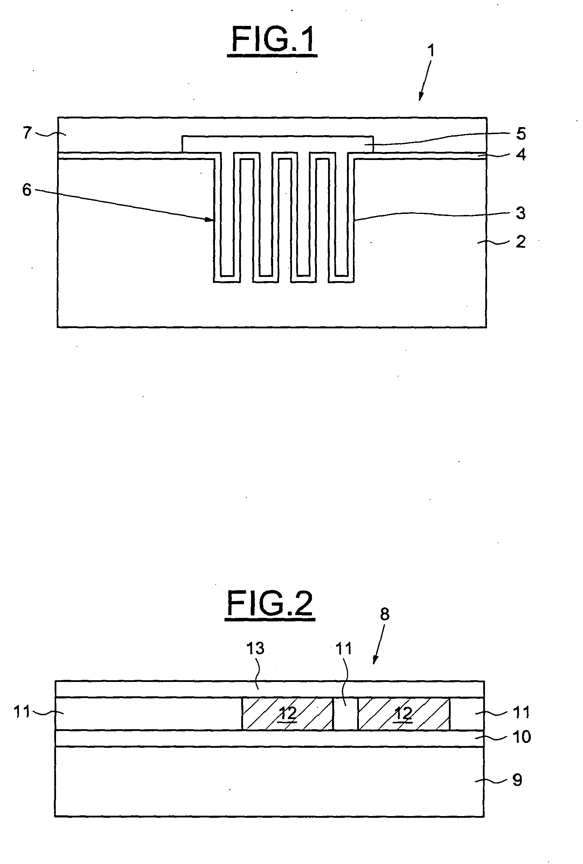

La figure 1 représente un sous-ensemble 1 d'un circuit intégré comprenant un substrat 2, pouvant être du silicium ou du silicium sur de l'oxyde enterré (SOI), dans lequel des tranchées creuses 3 ont été préalablement réalisées, par exemple par gravure chimique ou plasma. La profondeur des tranchées 3 est par exemple de l'ordre de 100 µm. Une couche de matériau diélectrique 4, pouvant être par exemple de l'oxyde de tantale (Ta₂O₅), du nitrure de silicium (SiN), de l'oxyde de silicium (SiO₂), de l'alumine (Al₂O₃), de l'oxyde d'hafnium (HfO₂) ou tout autre matériau diélectrique à forte permittivité, a ensuite été déposée sur le substrat 2 recouvrant ainsi les parois latérales et le fond des tranchées creuses 3. La couche diélectrique 4 peut être déposée par exemple par un procédé de type ALD (Atomic Layer Deposition en langue anglaise), LPCVD (Low Pressure Chemical Vapor Deposition en langue anglaise), PECVD (Plasma Enhanced Chemical Vapor Deposition en langue anglaise), chimique ou une combinaison de ces techniques. Une couche de métal 5, par exemple du tungstène, a ensuite été déposée sur le substrat 2 par dépôt chimique en phase vapeur CVD (Chemical Vapour Deposition en langue anglaise), ou du silicium poly cristallin dopé déposé par LPCVD, de façon à recouvrir la couche diélectrique 4 et à remplir les tranchées creuses 3. La couche de métal 5 se trouvant sur la surface de la couche diélectrique 4 peut subir éventuellement une étape de polissage mécano-chimique. Les extrémités de la couche 5 ont ensuite été retirées par photolithographie puis par gravure de manière à découvrir les extrémités de la couche diélectrique 4 du sous-ensemble 1. En variante, la couche diélectrique 4 peut être aussi gravée en même temps que la couche de métal 5. On réalise ainsi un condensateur tridimensionnel 6 obtenu à partir d'une succession d'électrodes formées à partir de la couche en métal 5 et espacées par la couche diélectrique 4.

Une couche isolante d'oxyde 7, a ensuite été déposée sur l'ensemble du substrat 2 de manière à recouvrir les extrémités de la couche de diélectrique 4 ainsi que la couche de métal 5. La couche d'oxyde 7 présente une épaisseur par exemple supérieure à 1 µm et est déposée de manière classique et connue en soi. L'épaisseur de la couche d'oxyde 7 doit être suffisamment importante de manière à assurer, après une étape de polissage mécano-chimique, une surface plane.

Le sous-ensemble 1 peut naturellement comprendre plusieurs types de composants passifs et notamment des inductances ou des résistances non représentées sur la figure 1 pour des raisons de commodités.

La figure 2 représente schématiquement un sous-ensemble 8 d'un circuit intégré comprenant un substrat 9, par exemple du silicium sur isolant (SOI), sur lequel est disposée une couche isolante 10, de préférence d'oxyde de silicium. La couche isolante 10 est surmontée elle-même par une couche comprenant des composants actifs 11 espacés entre eux par des régions isolantes 12. La couche comprenant des composants actifs 11 est également recouverte par une couche isolante 13, par exemple de l'oxyde de silicium. En d'autres termes, la couche comprenant des composants actifs 11 est prise en sandwich entre deux couches isolantes 10 et 13. La couche isolante 13 subit de préférence un polissage mécano-chimique.

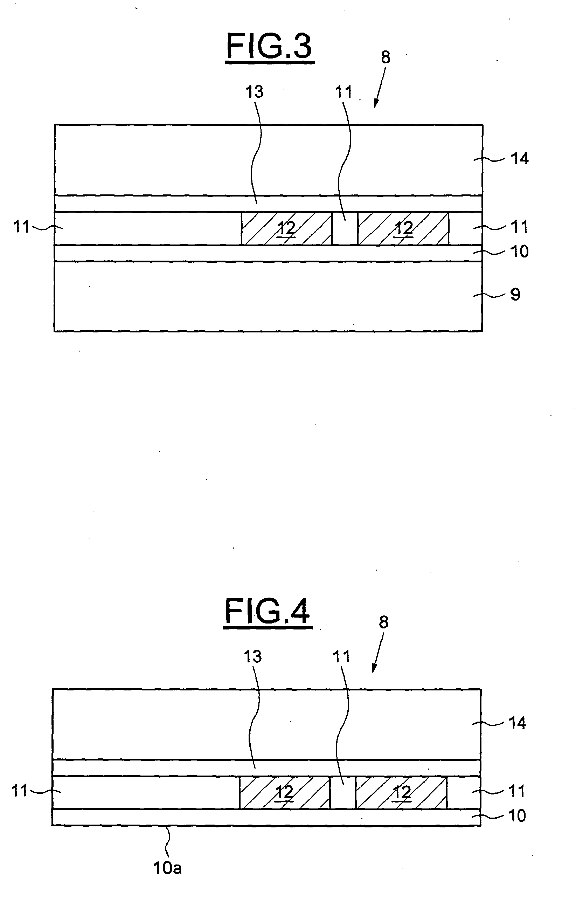

Un matériau 14, pouvant être un substrat rigide en silicium, est ensuite collé sur la couche d'oxyde 13 selon un procédé à basse température classique et connu en soi tel qu'illustré sur la figure 3. Le substrat rigide 14 ainsi déposé permet de pouvoir manipuler le sous-ensemble 8 afin de réaliser l'assemblage.

Le substrat 9 est ensuite éliminé par un procédé mécanique connu en soi puis par voie humide jusqu'au niveau de la surface inférieure 10a de la couche d'oxyde 10 tel que représenté sur la figure 4.

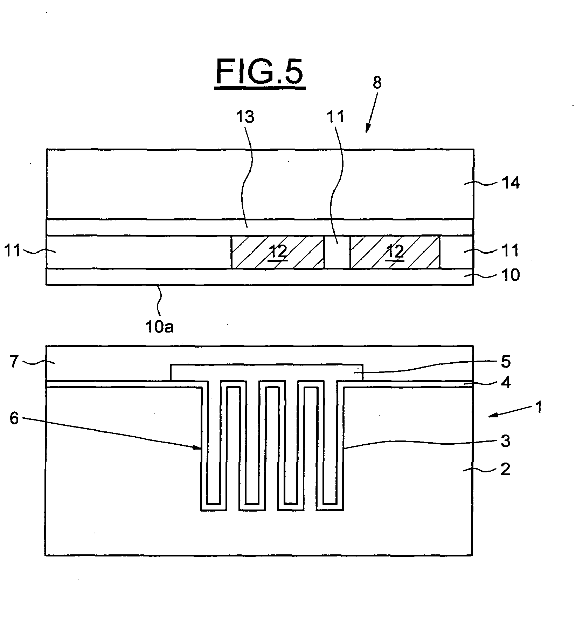

Le sous-ensemble 8 comprenant des composants actifs 11 est ensuite manipulé par l'intermédiaire du substrat rigide 14 de façon à le reporter sur le sous-ensemble 1 comprenant le condensateur 6 tel que représenté sur la figure 5. Ce report consiste notamment à fixer le sous-ensemble 8 sur le sous-ensemble 1 par l'intermédiaire d'un procédé de collage moléculaire à basse température. Le substrat rigide 14 permet de manipuler plus facilement le sous-ensemble 8 tout en minimisant l'influence de l'étape de fixation sur les caractéristiques des composants actifs 11.

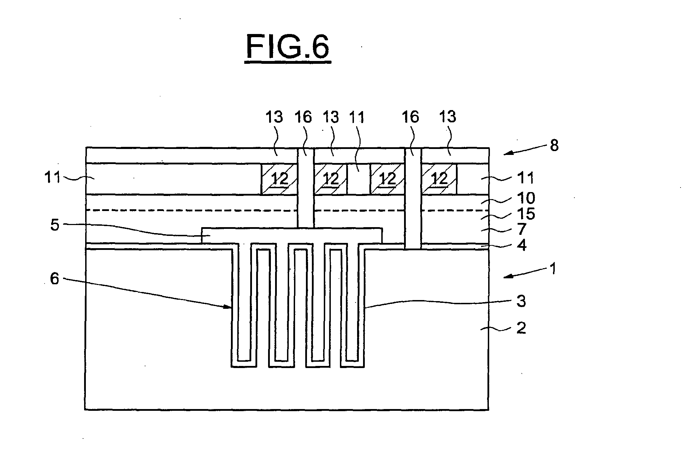

Le substrat rigide 14 est ensuite éliminé par un procédé mécanique connu en soi puis par voie humide tel qu'illustré sur la figure 6.

Comme l'indique la figure 6, les sous-ensembles 1 et 8 sont fixés mutuellement entre eux par l'intermédiaire d'une couche d'oxyde épaisse 15. Comme on le voit sur cette figure, 1a couche 15 résulte de la fixation de la couche d'oxyde 7 du sous-ensemble 1 comprenant le condensateur 6 avec la couche d'oxyde 10 du sous-ensemble 8 comprenant les composants actifs 11. En d'autres termes, comme il a été représenté en pointillés sur la figure 6, la couche d'oxyde 15 résulte du collage de la couche 7 sous la couche 10.

L'utilisation d'une couche d'oxyde, notamment d'oxyde de silicium (SiO₂), permet d'éviter qu'un décollement ne se produise lors de l'étape de collage des deux sous-ensembles. En outre, la couche d'oxyde 15 permet d'éviter les problèmes de compatibilité entre les matériaux des composants actifs 11 et les matériaux du condensateur 6. Plus particulièrement, l'épaisseur de la couche d'oxyde 15 permet de limiter les interactions électriques parasitaires entre les composants actifs 11 du sous-ensemble 8 et les composants passifs du sous-ensemble 1.

Des vias 16 ont ensuite été réalisés dans des zones isolantes dépourvues de composants actifs 11 par photolithographie puis par gravure sèche à travers les couches isolantes 13 et 15 et les régions isolantes 12 de manière à connecter le condensateur 6 du sous-ensemble 1.

Les vias 16 ont été ensuite remplis à l'aide d'un matériau présentant une conductivité électrique satisfaisante tel que par exemple du métal déposé par PVD (Physical Vapor Deposition en langue anglaise) ou CVD (chemical Vapor Deposition en langue anglaise). Une étape de polissage mécano chimique permet alors de dégager la surface du sous-ensemble 8. La réalisation des vias 16 après l'étape de fixation permet ainsi d'obtenir un bon contact ohmique de faible résistivité.

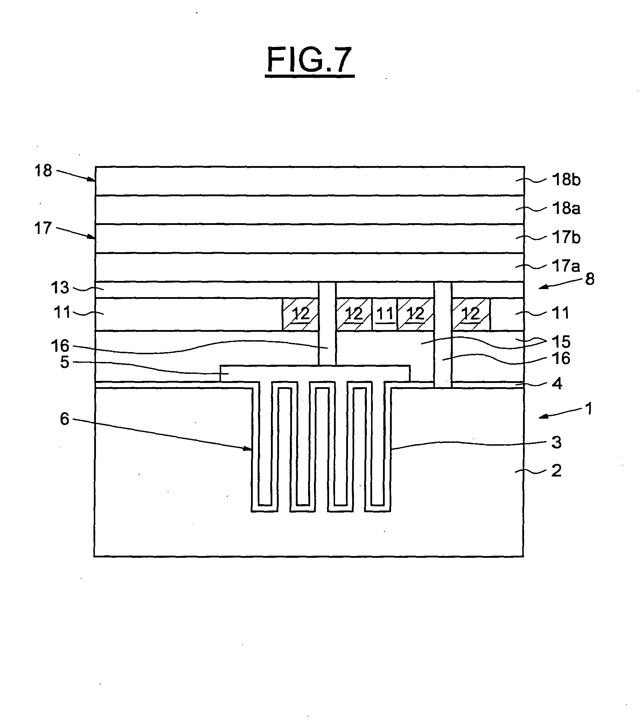

Comme illustré sur la figure 7, on réalise ensuite selon des étapes classiques connues de l'homme du métier, des niveaux d'interconnexions 17 et 18. Les niveaux d'interconnexions 17 et 18 comprennent respectivement des niveaux de métallisation 17a et 18a et des couches diélectriques 17b et 18b.

Ainsi les vias 16 traversent le sous-ensemble 8 comprenant des composants actifs 11 pour assurer une liaison électrique satisfaisante entre les niveaux d'interconnexions 17 et 18 situés au-dessus du sous-ensemble 8 et le condensateur 6.

Selon un autre mode de réalisation de l'invention, une étape optionnelle peut être ajoutée après le retrait du substrat 9 du sous-ensemble 8 jusqu'à la surface inférieure 10a de la couche d'oxyde 10 tel que représenté sur la figure 4. Cette étape optionnelle consiste à former des niveaux d'interconnexions sur la surface inférieure 10a de la couche d'oxyde 10.

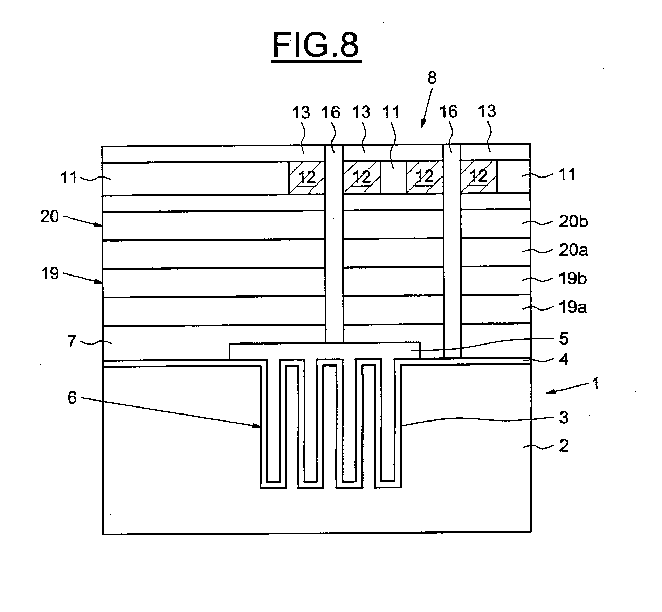

Ainsi après l'étape de fixation, des niveaux d'interconnexions 19 et 20 se situent entre le sous-ensemble 8 comprenant des composants actifs 11 et le sous-ensemble 1 comprenant le condensateur 6 tel qu'illustré sur la figure 8. Les niveaux d'interconnexions 19 et 20 comprennent respectivement des niveaux de métallisation 19a et 20a ainsi que des couches diélectrique 19b et 20b.

Un tel procédé permet de réaliser plus facilement un plus grand nombre d'interconnexions reliant le sous-ensemble 8 comprenant des composants actifs 11 et le sous-ensemble 1 comprenant le condensateur 6 réduisant ainsi avantageusement les problèmes d'alignement entre les deux sous-ensembles.

Ainsi, dans ce mode de réalisation, les vias 16 s'étendent également du sous-ensemble 8 comprenant des composants actifs 10 au sous-ensemble 1 comprenant le condensateur 6.

Selon un autre mode de réalisation, une autre étape optionnelle peut être ajoutée après le retrait du substrat 9 du sous-ensemble 8 jusqu'à la surface inférieure 10a de la couche d'oxyde 10 tel que représenté sur la figure 4. Cette étape optionnelle consiste à ajouter des plots conducteurs 21 sous certains composants actifs 10 du sous-ensemble 8.

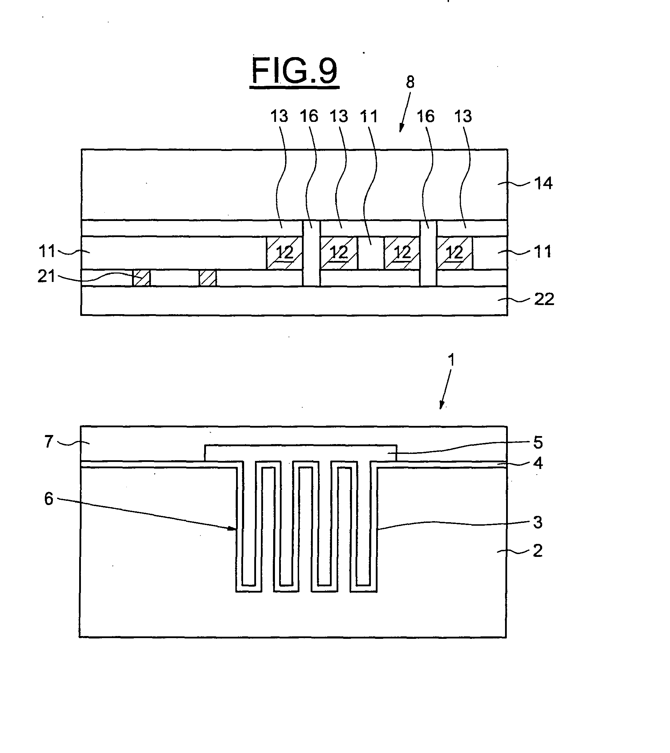

La figure 9 représente, au moment de l'étape de fixation par collage à basse température, un sous-ensemble 8 comprenant des composants actifs 11 recouverts par une couche isolante d'oxyde 13 et un sous-ensemble 1 comprenant le condensateur 6. Le sous-ensemble 8 est manipulé par l'intermédiaire du substrat rigide 14 de façon à le reporter sur le sous-ensemble 1 comprenant le condensateur 6.

Après le retrait du substrat 9, des plots conducteurs 21 ont été réalisés sous certains composants actifs 11 du sous-ensemble 8 à travers la couche d'oxyde 10. Les plots conducteurs 21 sont par exemple formés par gravure de la couche d'oxyde 10 puis par remplissage à partir d'un dépôt métallique.

Une couche d'oxyde 22 peut être ensuite déposée sur la surface inférieure 10a de la couche isolante 10 avant l'assemblage des deux sous-ensembles 8 et 1.

Les plots conducteurs 21 permettent de réduire localement la résistance du silicium sous les composants actifs 11, par exemple la résistance d'un collecteur de transistors bipolaires verticaux.

## Revendications

**1.** Circuit intégré comprenant au moins deux sous-ensembles :
- un sous-ensemble (8) comprenant des composants actifs (11),
- un sous-ensemble (1) comprenant des composants passifs (6),
**caractérisé par le fait que** ledit sous-ensemble (1) comprenant des composants passifs (6) est fixée sous ledit sous-ensemble (8) comprenant des composants actifs (11) et dans lequel des interconnexions (16) s'étendent d'un sous-ensemble (8) comprenant des composants actifs (11) à un sous-ensemble (1) comprenant des composants passifs (6).

**2.** Circuit intégré selon la revendication 1, dans lequel lesdits sous-ensembles sont fixés mutuellement par l'intermédiaire d'une couche (15) comprenant un matériau à base d'oxyde.

**3.** Circuit intégré selon la revendication 1, dans lequel lesdites interconnexions (16) traversent le sous-ensemble (8) comprenant des composants actifs (11).

**4.** Circuit intégré selon la revendication 3 dans lequel lesdites interconnexions (16) relient des composants passifs (6) à des niveaux d'interconnexions (17,18) disposés au-dessus du sous-ensemble (8) comprenant des composants actifs (11).

**5.** Circuit intégré selon l'une quelconque des revendications 1 à 3, dans lequel des niveaux d'interconnexions (19,20) se situent entre le sous-ensemble (8) comprenant des composants actifs (11) et le sous-ensemble (1) comprenant des composants passifs (6).

**7.** Circuit intégré selon l'une quelconque des revendications précédentes, dans lequel lesdites interconnexions (16) sont dans des zones isolantes du sous-ensemble (8) comprenant des composants actifs (11), lesdites zones isolantes étant dépourvues de composants actifs (11).

**8.** Procédé de fabrication d'un circuit intégré comprenant :
- une étape consistant à réaliser un sous-ensemble (1) comprenant des composants passifs (6),
- une étape consistant à réaliser un sous-ensemble (8) comprenant des composants actifs (11), et, ultérieurement,
- une étape consistant à fixer ledit sous-ensemble (1) comprenant des composants passifs (6) sous ledit sous-ensemble (8) comprenant des composants actifs (11), et
- une étape consistant à réaliser des interconnexions (16) afin de relier ledit sous-ensemble (8) comprenant des composants actifs (11) audit sous-ensemble (1) comprenant des composants passifs (6).

**9.** Procédé selon la revendication 8, dans lequel l'étape consistant à réaliser ledit sous-ensemble (8) comprenant des composants actifs (11) comprend une sous-étape consistant à déposer un matériau (14) permettant de manipuler ledit sous-ensemble (8).

**10.** Procédé selon l'une quelconque des revendications 8 ou 9, dans lequel l'étape consistant à réaliser ledit sous-ensemble (8) comprenant des composants actifs (11) comprend une sous-étape consistant à retirer dudit sous-ensemble (8) un substrat (9).

**11.** Procédé selon la revendication 10, dans lequel après le retrait du substrat (9), une étape de fixation dudit sous-ensemble (1) comprenant des composants passifs (6) est réalisée sous ledit sous-ensemble (8) comprenant des composants actifs (11).

**12.** Procédé selon la revendication 10, dans lequel après le retrait du substrat (9), une étape consistant à réaliser des niveaux d'interconnexions (19,20) est mise en oeuvre entre ledit sous-ensemble (8) comprenant des composants actifs (11) et ledit sous-ensemble (1) comprenant des composants passifs (6).

**13.** Procédé selon la revendication 10, dans lequel après le retrait du substrat (9), on ajoute des plots conducteurs (21) sous des composants actifs (11) dudit sous-ensemble (8).
